# EUROPEAN PATENT APPLICATION

(11) **EP 4 759 977 A1**
(43) Date of publication of application: **17.06.2026**
(21) Application number: 24890997.0
(22) Date of filing: 12.06.2024
(51) Int. Cl.: C30B 29/40, H01L 21/304, H01L 21/306

(54) **INDIUM PHOSPHIDE SUBSTRATE AND SEMICONDUCTOR EPITAXIAL WAFER**

(30) Priority: 13.11.2023 JP 2023193170
(71) Applicant: JX Advanced Metals Corporation, Tokyo 105-8417 (JP)
(72) Inventor: OKA,Shunsuke, Kitaibaraki-shi, Ibaraki 319-1535 (JP); YAMAGISHI,Kodai, Kitaibaraki-shi, Ibaraki 319-1535 (JP); SUZUKI,Kenji, Kitaibaraki-shi, Ibaraki 319-1535 (JP)
(74) Representative: Yeadon IP Limited
(86) International application number: PCT/JP2024/021402
(87) International publication number: WO 2025/104951

(57) **Abstract**

To provide an indium phosphide substrate having a diameter of 50 mm or more,
wherein a waviness Wq of the entire substrate surface excluding an edge portion is 200 nm or less, and
the waviness Wq of the entire substrate surface excluding the edge portion is measured according to the steps (1) and (2).

## Description

### FIELD OF THE INVENTION

The present invention relates to an indium phosphide substrate and a semiconductor epitaxial wafer.

### BACKGROUND OF THE INVENTION

Indium phosphide (InP) is a III-V compound semiconductor material composed of indium (In) from group III and phosphorus (P) from group V. As a semiconductor material, it has a band gap of 1.35 eV and an electron mobility of approximately 5400 cm/V·s or below, with higher electron mobility under high electric fields than other common semiconductor materials such as silicon and gallium arsenide. Furthermore, its stable crystal structure at room temperature and pressure is a cubic zinc blende structure, and its lattice constant is larger than that of compound semiconductors such as gallium arsenide (GaAs) and gallium phosphide (GaP).

In silicon photonics, a device is created by epitaxially growing an InP substrate and then bonding it to a Si substrate using bonding or other methods. In this bonding process, adhesion between the InP epitaxial growth layer and the Si device is extremely important for device performance. However, waviness on the substrate surface propagates to the film surface after epitaxial growth, which is thought to affect the accuracy of bonding. Thus, controlling the waviness of the InP epitaxial growth layer surface when bonding it to the Si device is extremely important.

Patent Literature 1 discloses a technique for suppressing surface waviness of an InP wafer by performing mirror polishing on a rotary polishing table with a polishing cloth using a predetermined InP wafer mirror polishing liquid.

Patent Literature 2 discloses a method for grinding semiconductor wafers, in which semiconductor wafers are attached to the surfaces of multiple disk-shaped chucks rotatably arranged on a circle, a disk-shaped grinding wheel at least the size of the circumference is rotated in the direction opposite to the rotation of the chucks, and water and then drying gas are sprayed from a nozzle provided at the center of the grinding wheel, in which the chuck and the grinding wheel are brought relatively close to each other in the direction of the rotation axis to maintain a constant contact area between the wafer and the grinding wheel, and multiple wafers are ground together to a predetermined thickness. In this method, the chuck and the grinding wheel are brought relatively close to each other in the direction of the rotation axis to bring them into contact with each other, water and then drying gas are sprayed from the nozzle, and the grinding wheel grinds the surfaces of multiple wafers together to a predetermined thickness, thereby suppressing waviness of the substrate.

Patent Literature 3 discloses a method for polishing indium phosphide, characterized by using a mixed solution of a solution of bromine dissolved in methyl alcohol and an aqueous solution of silica colloid. By polishing the substrate by adjusting the mixed solution in this way, waviness of the substrate due to etch pits is suppressed.

### CITATION LIST

### Patent Literatures

[Patent Literature 1] Japanese Unexamined Patent Application Publication No.7-027881
[Patent Literature 2] Japanese Patent No. 3316939
[Patent Literature 3] Japanese Unexamined Patent Application Publication No.58-145604

### SUMMARY OF THE INVENTION

As mentioned above, when epitaxial growth is performed on an InP substrate and then bonded to a Si substrate to form a device, adhesion between the InP epitaxial growth layer and the Si device is extremely important for the device characteristics, but waviness on the substrate surface propagates to the film surface after epitaxial growth and is thought to affect the accuracy of bonding. For this reason, if epitaxial growth is performed using an InP substrate with large waviness over the entire surface, there is a problem of poor bonding.

The techniques disclosed in Patent Literatures 1 and 2 are intended to suppress waviness of the substrate, but there is no disclosure as to the extent to which waviness is suppressed over the entire substrate.

Furthermore, the technology disclosed in Patent Literature 3 is for suppressing waviness of a substrate caused by etch pits, and focuses on local waviness of the substrate and relates to a technology for suppressing the local waviness. Thus, Patent Literature 3 does not disclose a technology for suppressing waviness over the entire substrate.

The present invention has been made to solve the above-mentioned problems, and has an object to provide an indium phosphide substrate and a semiconductor epitaxial wafer with reduced surface waviness.

The above problems are solved by the embodiments of the present invention, which are specified as follows.
[1] An indium phosphide substrate having a diameter of 50 mm or more,
   wherein a waviness Wq of the entire substrate surface excluding an edge portion is 200 nm or less.
[2] The indium phosphide substrate according to [1], wherein the waviness Wq of the entire substrate surface excluding the edge portion is 100 to 200 nm.
[3] The indium phosphide substrate according to [1] or [2], wherein the diameter is 50 to 150 mm.
[4] A semiconductor epitaxial wafer comprising the indium phosphide substrate according to any one of [1] to [3], and an epitaxial crystal layer provided on a main surface of the indium phosphide substrate.

According to the embodiments of the present invention, it is possible to provide an indium phosphide substrate and a semiconductor epitaxial wafer with reduced surface waviness.

### BRIEF DESCRIPTION OF THE DRAWINGS

FIG. 1 is a schematic diagram of the surface of an indium phosphide substrate according to an embodiment of the present invention.
FIG. 2 is a schematic diagram of a wafer surface for explaining a method for calculating waviness Wq.

### DETAILED DESCRIPTION OF THE INVENTION

Next, embodiments of the present invention will be described in detail with reference to the drawings. It should be understood that the present invention is not limited to the following embodiments, and that appropriate design changes and improvements may be made based on the ordinary knowledge of those skilled in the art without departing from the spirit of the present invention.

### [Indium Phosphide Substrate]

The following describes the configuration of the indium phosphide substrate of this embodiment.

The indium phosphide (InP) substrate of this embodiment comprises a substrate front surface (main surface), a substrate back surface, and an edge portion. The edge portion may have an orientation flat (OF) indicating the crystal orientation and an index flat (IF) for distinguishing the main surface of the substrate from its back surface.

The main surface of the indium phosphide substrate can be the surface on which an epitaxial crystal layer is formed. The surface on which an epitaxial crystal layer is formed is the surface on which epitaxial growth is actually performed when the indium phosphide substrate of this embodiment is used as an epitaxial growth substrate for forming a semiconductor device structure.

The main surface of the indium phosphide substrate is formed with a diameter of 50 mm or more. The diameter of the main surface of the indium phosphide substrate may also be 50 to 150 mm. The planar shape of the indium phosphide substrate may be circular or rectangular, such as square.

The thickness of the indium phosphide substrate is not particularly limited, but is preferably 300 to 900 µm, and more preferably 300 to 700 µm. In particular, when the diameter (caliber) of the indium phosphide substrate is large, a thickness of less than 300 µm can lead to cracking, while a thickness of more than 900 µm can result in waste of the base crystal.

The indium phosphide substrate of this embodiment may contain, as a dopant (impurity), Zn (zinc) to achieve a carrier concentration of 1×10¹⁶ cm⁻³ or more and 1×10¹⁹ cm⁻³ or less, S (sulfur) to achieve a carrier concentration of 1×10¹⁶ cm⁻³ or more and 1×10¹⁹ cm⁻³ or less, Sn (tin) to achieve a carrier concentration of 1×10¹⁶ cm⁻³ or more and 1×10¹⁹ cm⁻³ or less, or Fe (iron) to achieve a resistivity of 1×10⁵ Ωcm or more and 1×10⁶ Ωcm or less.

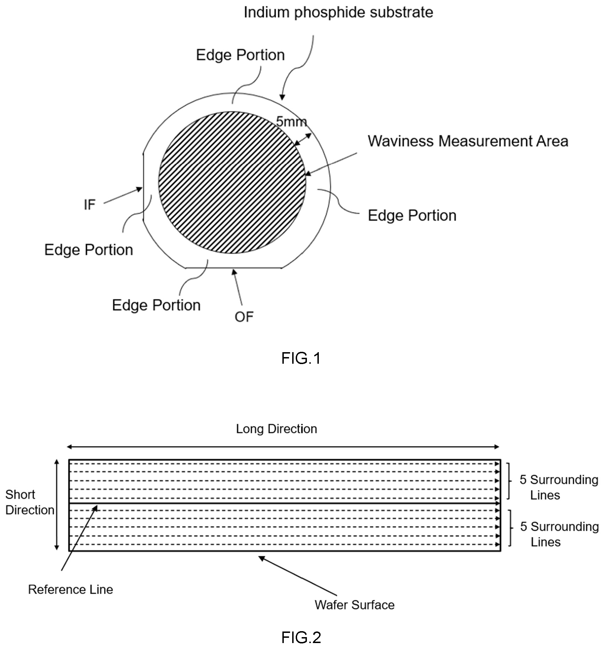

FIG. 1 shows a schematic diagram of the surface of an indium phosphide substrate according to an embodiment of the present invention. The indium phosphide substrate is formed in a roughly disc shape and has OF and IF. Note that FIG. 1 is a diagram for understanding the edge portion of an indium phosphide substrate according to an embodiment of the present invention, and the indium phosphide substrate according to an embodiment of the present invention is not limited to this shape. In particular, it does not have to have OF and IF.

In an indium phosphide substrate according to an embodiment of the present invention, the waviness Wq of the entire substrate surface excluding the edge portion is controlled to 200 nm or less. Here, in the present invention, the area within approximately 5 mm from the outer periphery of the wafer to the center, excluding the effects of roll-off, is defined as the "edge portion," and the entire wafer surface excluding the area within 5 mm from the outer periphery of the wafer to the center, excluding the effects of roll-off, is defined as the "entire substrate surface excluding the edge portion." In other words, in the present invention, the "entire substrate surface excluding the edge portion" refers to the central circular area indicated as the "waviness measurement area" in FIG. 1.

Since the entire surface of a wafer is ground simultaneously, measuring the center, excluding the edge (a region within approximately 5 mm from the outer periphery to the center) where roll-off occurs due to polishing, results in a representative measurement of the waviness of the entire wafer. Furthermore, because the waviness is periodic, it is thought to be constant regardless of diameter.

**In** this invention, the "waviness Wq" of the entire substrate surface excluding the edge portion is the "root mean square waviness" defined in JIS B 0601:2013. Measuring this waviness Wq makes it possible to quantify the average waviness of the entire substrate surface excluding the edge.

The waviness Wq of the entire substrate surface excluding the edge portions of the indium phosphide substrate can be measured using the white light interferometry function of a laser microscope VKX-3000 manufactured by Keyence Corp. When measuring the waviness Wq of the entire substrate surface excluding the edge portions of the indium phosphide substrate, a 10x interferometric lens is used to measure the waviness (Wq: root mean square waviness) curve as a profile curve over an approximately 1 mm x 40 mm area, with the center of the wafer being the center of the measurement range, and the waviness is determined with a cutoff wavelength λc of 25 mm. To calculate the waviness Wq, as shown in Figure 2, the center of the short direction of an approximately 1 mm x 40 mm area on the substrate surface is used as a reference line, and 20 lines spaced approximately 4.5 µm apart (the basic spacing specified for the VKX-3000 laser microscope) are used as one measurement interval (approximately 4.5 µm x 20 lines = approximately 90 µm intervals). The waviness over a long direction of 40 mm is calculated for a total of 11 lines, including 10 surrounding lines moved parallel to the short direction and the reference line The average value is taken as Wq. This average value is measured automatically using the white light interferometry function of the Keyence Corporation VKX-3000 laser microscope.

Measurements are performed in a clean room maintained at a room temperature of 22±5°C to ignore the effects of thermal expansion and other factors. The various settings for the white light interferometry function of the VKX-3000 laser microscope are as follows:
- Tilt Correction: Automatic
- DCL/BCL: None
- Measurement Type: Waviness
- Cutoff Wavelength: λs and λf are not set. λc is 25 mm.
- End Effect Correction: Enabled
- Double Gaussian: Off
- Stylus Mode: Off
- Number of Reference Wavelengths: 1
- Number of Profiles: 11

Since the entire wafer is ground simultaneously, there is no positional dependency within the surface. Therefore, evaluating the waviness curve of the above portion represents the waviness of the entire wafer, which is required for the bonding process. Furthermore, since waviness is periodic, it is believed to be consistent regardless of diameter.

If the waviness Wq of the entire substrate surface, excluding the edge portions, of the indium phosphide substrate is 200 nm or less, the surface waviness after epitaxial growth is reduced, and even when bonded to a Si substrate containing a Si device, poor adhesion due to the influence of waviness can be effectively suppressed. The waviness Wq of the entire substrate surface, excluding the edge portions of the indium phosphide substrate, is preferably 180 nm or less, more preferably 150 nm or less. Furthermore, the lower limit of the waviness Wq is not particularly limited, but Wq may be 100 to 200 nm.

### [Method for Manufacturing an Indium Phosphide Substrate]

Next, a method for manufacturing an indium phosphide substrate according to an embodiment of the present invention will be described.

The method for manufacturing an indium phosphide substrate involves first preparing an indium phosphide ingot using a known method.

The indium phosphide ingot is then ground into a cylindrical shape. At this time, an orientation flat (OF) and an index flat (IF) may be formed at predetermined positions on the outer periphery of the wafer.

Next, wafers having a main surface and a back surface are cut from the ground indium phosphide ingot. Both ends of the indium phosphide ingot's crystal are cut along predetermined crystal planes using a wire saw or similar to cut multiple wafers with thicknesses of 750 to 850 µm.

In the wafer cutting process, it is preferable to constantly feed new wire while moving the wire back and forth horizontally, and to move the stage carrying the indium phosphide ingot vertically toward the wire.

The conditions for cutting the ingot using a wire saw are as follows:
- New wire feed rate: 10-60 m/min
- Wire reciprocating speed: 300-350 m/min
- Vertical movement speed of the stage carrying the indium phosphide ingot: 200-400 µm/min
- Wire saw abrasive grain management:
   Use GC #1200 abrasive grain and PS-LP-500D cutting oil. The abrasive grain viscosity is controlled to 300-400 mPa·s when the viscometer rotor shaft rotates at 60 rpm. This viscosity can be measured using a TVB-10 viscometer manufactured by Toki Sangyo Co., Ltd.

Next, to remove the damaged layers created during the wire saw cutting process, the cut wafers are etched on both sides with a specified etching solution (primary etching). The wafers can be etched by immersing the entire wafer in the etching solution. As the etching solution, for example, a mixed solution of 85 mass % phosphoric acid aqueous solution and 30 mass % hydrogen peroxide solution is preferably used, and etching is preferably performed from both sides to a total depth of 5 to 15 µm.

Next, the outer periphery of the wafer is chamfered to a diameter of 50 mm or more. After chamfering, both sides of the wafer are roughly polished. This rough polishing process, also known as the lapping process, involves polishing with a specified abrasive to remove irregularities from the wafer surface while maintaining its flatness. When cutting using a wire saw as described above, wire vibration causes waviness across the entire wafer. The inventors discovered that to remove this waviness, it is necessary to remove the waviness by lapping after slicing (the process of cutting wafers from an ingot). Specifically, a total thickness of 100 µm or more must be removed by lapping on the front and back sides of the wafer while applying a pressure of 100 g/cm² or more. Note that, to increase the amount of lapping, it is preferable to increase the thickness of the wafer during slicing, if necessary.

Next, the wafer is etched on both sides using a specified etching solution (secondary etching). The wafer can be etched by immersing the entire wafer in the etching solution. The etching solution is preferably a mixture of 85% by mass phosphoric acid, 30% by mass hydrogen peroxide, and ultrapure water, and is used to etch a total of 7 to 15 µm from both sides.

Next, both sides of the wafer are polished. This process removes any waviness that could not be completely eliminated by the lapping process described above. From a productivity perspective, it is preferable to simultaneously polish multiple wafers on both sides. To uniformly remove waviness across all wafers being polished simultaneously, when polishing both sides of the wafer using the upper and lower platens, it is necessary to supply sufficient polishing liquid to the wafer from multiple polishing liquid supply ports so that the polishing liquid fully penetrates the entire polishing pads on the upper and lower platens. Specifically, supplying polishing liquid at a flow rate of 0.07 mL/min·cm² or more per area of the upper or lower platen enables uniform polishing of both sides of the wafer. As a result, it is possible to remove waviness that could not be completely eliminated by the lapping process. In this way, the waviness Wq of the entire substrate surface excluding the edges can be controlled to 200 nm or less.

Next, the main surface of the wafer is polished with a mirror polishing abrasive to a mirror finish.

Next, cleaning is performed to produce an indium phosphide substrate according to an embodiment of the present invention. Alternatively, after the above-mentioned mirror finish, an indium phosphide substrate may be produced by etching, mirror polishing, cleaning, etc.

### [Semiconductor Epitaxial Wafer]

**In** accordance with an embodiment of the present invention, epitaxial growth of semiconductor thin films on the main surface of an indium phosphide substrate using known methods can form epitaxial crystal layers, resulting in the fabrication of a semiconductor epitaxial wafer. An example of this epitaxial growth is a HEMT structure formed by epitaxially growing an InAlAs buffer layer, an InGaAs channel layer, an InAlAs spacer layer, and an InP electron supply layer on the main surface of the indium phosphide substrate. When fabricating a semiconductor epitaxial wafer with such a HEMT structure, a mirror-finished indium phosphide substrate is typically etched using an etchant such as sulfuric acid/hydrogen peroxide to remove impurities such as silicon (Si) adhering to the substrate surface. With the back surface of the indium phosphide substrate after this etching process supported in contact with a susceptor, an epitaxial crystal layer is formed on the main surface of the indium phosphide substrate by molecular beam epitaxy (MBE) or metal organic chemical vapor deposition (MOCVD).

Since the semiconductor epitaxial wafer according to an embodiment of the present invention is fabricated using an indium phosphide substrate according to an embodiment of the present invention, in which waviness across the entire substrate surface is suppressed as described above, surface waviness after epitaxial growth is reduced, and poor adhesion due to the effects of waviness is effectively suppressed even when the wafer is bonded to a Si substrate containing a Si device.

### EXAMPLES

The following examples are provided to provide a better understanding of the present invention and its advantages, but the present invention is not limited to these examples.

### (Examples 1 and 2)

Examples 1 and 2 were fabricated as follows.

First, an indium phosphide ingot was prepared.

Next, the indium phosphide ingot was ground into a cylindrical shape. An orientation flat (OF) and an index flat (IF) were formed at predetermined positions on the outer periphery of the wafer.

Next, wafers having a main surface and a back surface were cut from the ground indium phosphide ingot. Both ends of the indium phosphide ingot's crystal were cut along predetermined crystal planes using a wire saw or similar tool, resulting in multiple wafers with a thickness of 0.84 mm.

During the wafer cutting process, a wire was moved back and forth horizontally while constantly feeding new wire, and the stage carrying the indium phosphide ingot was moved vertically toward the wire.

The conditions for cutting the ingot using a wire saw are shown below.
- New wire feed speed: 10-60 m/min
- Wire reciprocating speed: 320 m/min
- Vertical movement speed of the stage carrying the indium phosphide ingot: 330 µm/min
- Wire saw abrasive grain control:
   GC #1200 abrasive grains and PS-LP-500D cutting oil were used. The abrasive grains were controlled to achieve a viscosity of 300-400 mPa·s when the viscometer rotor shaft rotated at 60 rpm. This viscosity was measured using a TVB-10 viscometer manufactured by Toki Sangyo Co., Ltd.

Next, to remove the damaged layer created during the wire saw cutting process, the cut wafers were etched on both sides by a total of 15 µm using a mixed solution of 85% by mass phosphoric acid aqueous solution and 30% by mass hydrogen peroxide (primary etching). The wafers were etched by immersing the entire wafer in the etching solution.

Next, the outer periphery of the wafer was chamfered to a diameter of 50 mm or more. After chamfering, both sides of the wafer were roughly polished (lapped). Specifically, a total thickness of 120 µm was removed from the front and back of the wafer by lapping while applying a pressure of 150 g/cm².

Next, the wafer was etched to a total of 7 µm from both sides using a mixed solution of 85% by mass phosphoric acid aqueous solution, 30% by mass hydrogen peroxide solution, and ultrapure water (secondary etching). The wafer was etched by immersing the entire wafer in the etching solution.

Next, both sides of the wafer were polished. This process was performed to remove any waviness that could not be completely removed by the above lapping process. In this double-side polishing process, when polishing both sides of the wafer using the upper and lower platens, sufficient polishing liquid was supplied to the wafer from multiple polishing liquid supply ports so that the polishing liquid would fully penetrate the entire polishing pads on the upper and lower platens. Specifically, the polishing liquid was supplied at a flow rate of 0.072 mL/min·cm² (total amount of polishing liquid) per area of the upper or lower platen. The areas of the upper and lower platens used were each 5608 cm².

Next, the main surface of the wafer was polished to a mirror finish using a mirror-polishing abrasive.

Next, cleaning was performed to produce an indium phosphide substrate sample with a diameter of 76.2 mm and the shape shown in Figure 1.

### (Comparative Examples 1-5)

In Comparative Examples 1-5, indium phosphide substrate samples with a diameter of 76.2 mm and the shape shown in Figure 1 were fabricated under the same conditions as in Examples 1 and 2, except that a total of 40 µm of the wafer was removed from both the front and back surfaces during the lapping process, and the total polishing solution volume in the double-sided polishing process after the secondary etching was set to 0.065 mL/min·cm².

### (Evaluation of Waviness Wq)

For the indium phosphide substrate samples of Examples 1 and 2 and Comparative Examples 1-5, the waviness Wq of the entire substrate surface, excluding the edge portions, was measured using the following method.

In other words, for each of the 76.2 mm diameter indium phosphide substrate samples of Examples 1 and 2 and Comparative Examples 1-5, which had IF and OF as shown in Figure 1, the area extending from the outer periphery to the center within approximately 5 mm was defined as the "edge portion," and the entire wafer surface, excluding the area extending from the outer periphery to the center within 5 mm, excluding the effects of roll-off, was defined as the "entire substrate surface excluding the edge portion."

Next, the waviness Wq of the waviness measurement area was measured using the white light interferometry function of a Keyence Corporation VKX-3000 laser microscope. This measurement was performed using a 10x magnification interferometer lens, measuring the waviness curve over an approximately 1 mm x 40 mm area, with the wafer center positioned at the center of the measurement range. The waviness was calculated using a cutoff wavelength of λc = 25 mm. To calculate the waviness Wq, as shown in Figure 2, the center of the short direction of the substrate surface within the approximately 1 mm x 40 mm area was used as the reference line. 20 lines spaced approximately 4.5 µm apart (the basic interval specified for the VKX-3000 laser microscope) were used as one measurement interval (approximately 4.5 µm x 20 lines = approximately 90 µm intervals), and the waviness was calculated over a 40 mm long direction for 11 lines, including 10 surrounding lines moved parallel to the short direction, and the reference line. The average value was calculated as Wq. This average value was automatically measured using the white light interferometry function of the Keyence Corporation VKX-3000 laser microscope. The measurements were performed in a clean room maintained at a temperature of 22±5°C to minimize the effects of thermal expansion. The settings for the white light interferometry measurement function of the VKX-3000 laser microscope were as follows:
- Tilt correction: Automatic
- DCL/BCL: None
- Measurement type: Waviness
- Cutoff wavelength: λs and λf not set. λc was 25 mm.
- End effect correction: Enabled
- Double Gaussian: Off
- Stylus mode: Off
- Number of reference wavelengths: 1
- Number of profiles: 11

The manufacturing conditions and evaluation results described above are shown in Table 1.

**Table 1**

| | **Diameter (mm)** | **Total lapping volume of front and back surfaces of the wafer (um)** | **Total amount of polishing liquid (mL/min · cm²)** | **Wq (nm)** |
|---|---|---|---|---|
| **EX.1** | **76.2** | **120** | **0.072** | **118.1** |
| **EX.2** | **76.2** | **120** | **0.072** | **178.9** |
| **Comp EX.1** | **76.2** | **40** | **0.065** | **249.6** |
| **Comp EX.2** | **76.2** | **40** | **0.065** | **306.1** |
| **Comp EX.3** | **76.2** | **40** | **0.065** | **281.6** |
| **Comp EX.4** | **76.2** | **40** | **0.065** | **296.3** |
| **Comp EX.5** | **76.2** | **40** | **0.065** | **228.8** |

### (Discussion)

In both Examples 1 and 2, the waviness Wq of the entire substrate surface, excluding the edge, was 200 nm or less, demonstrating good suppression of surface waviness.

In contrast, in Comparative Examples 1 to 5, the waviness Wq of the entire substrate surface, excluding the edge, exceeded 200 nm.

Note that in Examples 1 and 2, the total lapping volume of the wafer on both the front and back surfaces was 120 µm, and the total polishing liquid volume on both the front and back surfaces was also the same at 0.072 mL/min·cm², but the waviness Wq of the entire substrate surface, excluding the edge, was different, at 118.1 nm and 178.9 nm, respectively. Similarly, in Comparative Examples 1 to 5, the total lapping volume of the wafer on both the front and back surfaces was 40 µm, and the total polishing liquid volume on both the front and back surfaces was also the same at 0.065 mL/min·cm², but the waviness Wq of the entire substrate surface, excluding the edge, was different, ranging from 228.8 to 306.1 nm. This is thought to be because variations in temperature during wire saw cutting result in different waviness after cutting.

## Claims

1. An indium phosphide substrate having a diameter of 50 mm or more,
wherein a waviness Wq of the entire substrate surface excluding an edge portion is 200 nm or less, and
the waviness Wq of the entire substrate surface excluding the edge portion is measured according to the following steps (1) and (2).
(1) For the indium phosphide substrate, an area within 5 mm from outer periphery to center is defined as the "edge portion," and an entire wafer surface excluding the area within 5 mm from the outer periphery to the center is defined as the "entire substrate surface excluding the edge portion."
(2) Next, the waviness Wq is measured using a white light interferometry function of a laser microscope, a 10x interferometry lens is used for the measurement, and a waviness curve is measured over a 1 mm x 40 mm area, with the center of the wafer positioned at a center of a measurement range, and the waviness is determined with a cutoff wavelength λc of 25 mm, and when calculating the waviness Wq, the center of a short direction of a 1 mm x 40 mm area of the substrate surface is used as a reference line, and 20 lines spaced 4.5 µm apart are used as one measurement interval, the waviness over a long direction of 40 mm is calculated for a total of 11 lines, including 10 surrounding lines moved parallel to the short direction and the reference line, and an average value is taken as the waviness Wq.

2. The indium phosphide substrate according to claim 1, wherein the waviness Wq of the entire substrate surface excluding the edge portion is 100 to 200 nm.

3. The indium phosphide substrate according to claim 1 or 2, wherein the diameter is 50 to 150 mm.

4. A semiconductor epitaxial wafer comprising the indium phosphide substrate according to claim 1 or 2, and an epitaxial crystal layer provided on a main surface of the indium phosphide substrate.

5. A semiconductor epitaxial wafer comprising the indium phosphide substrate of claim 3 and an epitaxial crystal layer formed on a main surface of the indium phosphide substrate.
